(19) Europäisches Patentamt / European Patent Office / Office européen des brevets

(11) **EP 1 865 547 A1**

(12) **EUROPEAN PATENT APPLICATION**
published in accordance with Art. 158(3) EPC

(43) Date of publication:
**12.12.2007 Bulletin 2007/50**

(51) Int Cl.:
*H01L 21/3065* (2006.01)   *H01L 21/027* (2006.01)
*H01L 21/22* (2006.01)   *H01L 21/265* (2006.01)

(21) Application number: **06730688.6**

(22) Date of filing: **30.03.2006**

(86) International application number:
**PCT/JP2006/306740**

(87) International publication number:
**WO 2006/106871 (12.10.2006 Gazette 2006/41)**

(84) Designated Contracting States:
**DE FR GB**

(30) Priority: **30.03.2005 JP 2005099148**

(71) Applicant: **MATSUSHITA ELECTRIC INDUSTRIAL CO., LTD.**
**Osaka 571-8501 (JP)**

(72) Inventors:
• **JIN, Cheng-Guo**
c/o Ultimate Junction Technologies Inc.,
Osaka 570-8501 (JP)

• **MIZUNO, Bunji**
c/o Ultimate Junction Technologies Inc.,
Osaka 570-8501 (JP)
• **SASAKI, Yuichiro**
c/o Ultimate Junction Technologies Inc.,
Osaka 570-8501 (JP)

(74) Representative: **Grünecker, Kinkeldey, Stockmair & Schwanhäusser**
**Anwaltssozietät**
**Maximilianstraße 58**
**D-80538 München (DE)**

(54) **ASHING APPARATUS, ASHING METHOD, AND IMPURITY DOPING APPARATUS**

(57)    To provide an asher, an ashing method and an impurity doping apparatus group which can detect the interface between a surface hardening layer of a resist and an internal nonhardening layer and the interface between the nonhardening layer and a semiconductor substrate, with a high throughput.

The invention provides the asher for plasma ashing the surface hardening layer formed on the resist and the internal nonhardening layer, the resist for use as a mask coated on the semiconductor substrate and doped with impurity, **characterized by** comprising an elipsometer for causing a linearly polarized light to enter the semiconductor substrate to detect a reflected, elliptically polarized light during plasma ashing, and detecting the interface between the hardening layer and the nonhardening layer and the interface between the nonhardening layer and the semiconductor substrate.

FIG. 1

**Description**

<TECHNICAL FIELD>

The present invention relates to an asher for ashing a resist, an ashing method and an impurity doping apparatus group, comprising interface detection means capable of detecting the interface between a surface hardening layer formed by impurity doping and an internal nonhardening layer or means for detecting the optical constants and the thickness of the surface hardening layer and the nonhardening layer in plasma ashing the resist after impurity doping.

<BACKGROUND ART>

Conventionally, an asher for use in the semiconductor industry has means for detecting an end point of ashing. For example, a resist ashing end point detection method has been described in patent document 1 as below. This resist ashing end point detection method involves detecting a change in the luminous intensity of hydrogen spectrum among plasma emission during an ashing process when the plasma ashing is mainly oxygen plasma, whereby the end point of resist ashing can be detected at high sensitivity.
Patent document 1: JP-A-6-124923

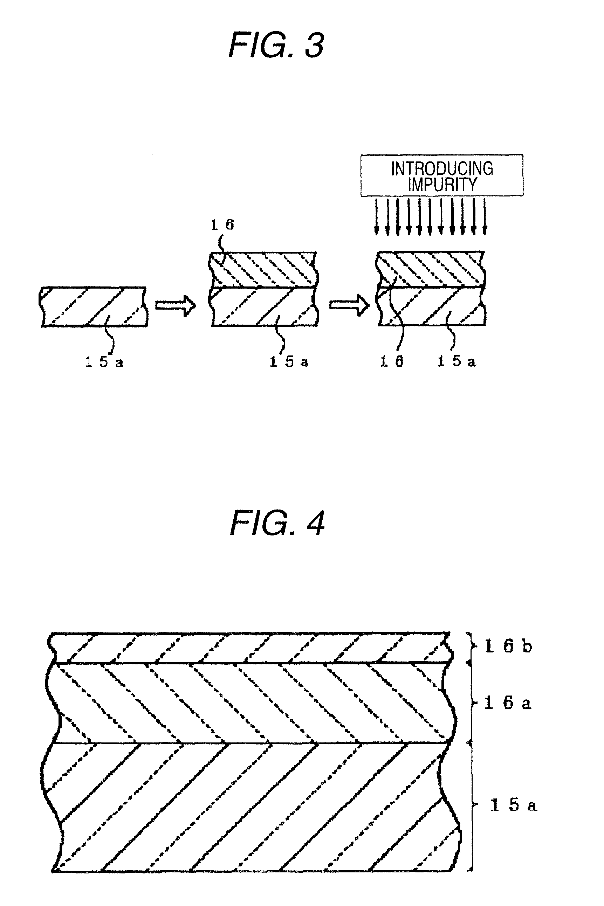

Fig. 3 is a view for explaining a process for implanting impurity into the resist of a semiconductor substrate, and Fig. 4 is a view showing a state where impurity is implanted. Usually, an impurity introduction process involves coating a resist 16 on the semiconductor substrate 15a to form a mask, selectively patterning, and introducing impurity into the semiconductor substrate 15a with an impurity introduction apparatus, as shown in Fig. 3.

Since the impurity is also introduced into the resist used as the mask, the surface is altered, so that a hardening layer 16b is formed, as shown in Fig. 4. Also, the inside of the resist is not affected by the impurity introduction process, and an nonhardening layer 16a in a state equivalent to the untreated resist. Of course, the film quality and film thickness of the hardening layer 16b depend on the dose and energy amount at the time of introducing impurity. In any way, the hardening layer 16b is firstly ashed and then the nonhardening layer 16a is ashed.

To ash this hardening layer 16b, it is required that the semiconductor substrate 15a is placed at low temperature to decrease the ashing rate to prevent peeling off of the surface layer due to popping causing contamination of the semiconductor substrate 15a. That is, to lower the temperature, the temperature of a heater is decreased, and the very low ashing rate condition is required to avoid temperature rise due to plasma. To ash the nonhardening layer 16a after the hardening layer 16b is ashed, it is ideally required to increase the ashing rate by placing the semiconductor substrate at high temperature.

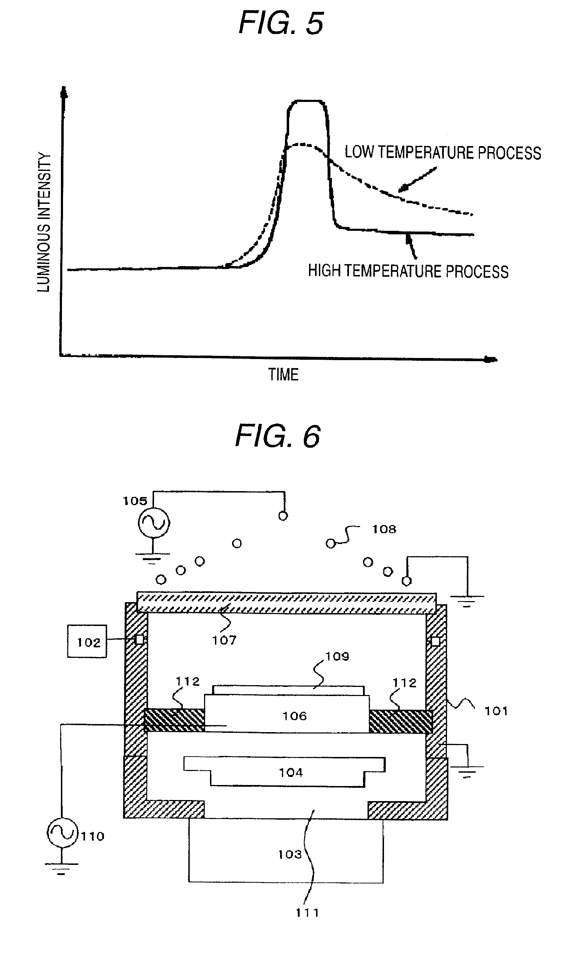

Fig. 5 is a graph showing the luminous intensity of spectral light emitted from a reaction product during a low temperature processing and a high temperature processing. However, with the ashing end point detection method as described above, a change in the luminous intensity is smaller in the low temperature processing than the high temperature processing, whereby the interface between the resist 16 and the semiconductor substrate 15a can be detected, but it is difficult that the interface between the hardening layer 16b of resist with impurity implanted and the nonhardening layer 16a is detected.

Particularly, it is sought to have a technique for forming a shallow junction along with the scale down of semiconductor device, and when the impurity is doped by a low energy plasma doping method, or using the low energy ion implantation, the thickness of the hardening layer is as thin as about 10nm, and it is more difficult to detect the interface between the hardening layer and the nonhardening layer.

<DISCLOSURE OF THE INVENTION>

<PROBLEMS THAT THE INVENTION IS TO SOLVE>

Accordingly, the hardening layer 16b and the nonhardening layer 16a had to be ashed at low temperature for enough time to suppress a pumping action. As a result, there is a problem that the ashing time is long and the throughput is remarkably low.

Accordingly, it was required to provide an asher and an ashing method capable of detecting the interface between the surface hardening layer of resist and the internal nonhardening layer and the interface between the nonhardening layer and the semiconductor substrate, and having high throughput.

Especially when the impurity introduction is made by plasma doping, a problem peculiar to the plasma doping arises. That is, in the case of plasma doping, unlike the conventional ion implantation, there is a feature that a large amount of other ions than desired impurity ions are introduced. For example, when it is desired that boron ions of 1 E15cm$^{-2}$ are implanted into the silicon substrate, boron ions of 1 E15cm$^{-2}$ are introduced into the silicon substrate by boron implantation. Boron ions of 1 E15cm$^{-2}$ are also implanted into the resist. On the other hand, a case of using the plasma doping will be described below. For example, when a gas plasma in which helium gas is mixed into $B_2H_6$ gas is used, hydrogen and helium, besides boron, are necessarily implanted. Herein, a mixture ratio of $B_2H_6$ gas and helium gas is typically 5% to 95%. In any way, if boron of $1E15cm^{-2}$ is implanted, hydrogen of twice $1E15cm^{-2}$ is implanted, and helium of much more amount is implanted. From the standpoint of resist, a case where boron of $1E15cm^{-2}$ is introduced by ion implantation and a case where it is implanted by plasma doping, the total amount of ions to be implanted is much greater in the latter case. For such reason, the surface hardening layer of resist is more easily formed by plasma doping. This invention discloses a measure for solving this problem.

Also, there is a problem in removing the resist in a process of making amorphous the surface of the silicon substrate with resist pattern using the plasma such as helium plasma. Herein, the desired impurity designates helium. If a large amount of helium ions are implanted, the surface hardening layer of resist is more easily formed.

As described above, the problem with the use of plasma doping is peculiar to the plasma doping, unlike ion implantation, and has been found by the inventors for the first time. The plasma doping has a feature that the dose rate is higher by a few digits than the conventional ion implantation. Generally, it is said to be higher by three digits. Thereby, in the processing for the same period of time, an amount of ions, which is greater by three digits than the ion implantation, are implanted into silicon and resist. On the other hand, if the processing time is extremely shorter by three digits, it is difficult to secure the uniformity and repeatability, which is unfavorable from the viewpoint of manufacturing. In this manner, the plasma doping had a peculiar problem.

<MEANS FOR SOLVING THE PROBLEMS>

Thus, the invention provides an asher for plasma ashing a surface hardening layer formed on a resist and an internal nonhardening layer, the resist for use as a mask coated on a semiconductor substrate and doped with impurity, characterized by comprising an elipsometer for causing a linearly polarized light to enter the semiconductor substrate to detect a reflected, elliptically polarized light during plasma ashing, and detecting the interface between the hardening layer and the nonhardening layer and the interface between the nonhardening layer and the semiconductor substrate.

Thereby, immediately after the end of ashing the hardening layer is detected, the ashing of the nonhardening layer can be started by elevating the temperature to increase the ashing rate, whereby the throughput is increased. And if the end of ashing the nonhardening layer is detected, the ashing process is ended.

Also, if the end of ashing the hardening layer is detected, the ashing process may be ended. And the removal of the nonhardening layer may be made by another process such as wet etching.

Also, the invention provides a method for analyzing the elipsometer, characterized by including detecting the reflected, elliptically polarized light and detecting the optical constants and the thickness of the hardening layer and the nonhardening layer. By detecting the changes in the optical constants and the thickness of the hardening layer and the nonhardening layer, the end time of ashing the hardening layer and the nonhardening layer can be predicted, whereby the throughput is increased and fed back to the ashing process at the same time.

Also, in the invention, the asher comprises a feedback control mechanism for feeding the detected interface between the hardening layer and the nonhardening layer and interface between the hardening later and the semiconductor substrate, or the optical constants and the thickness of the hardening layer and the nonhardening layer back to the asher.

With the feedback control mechanism, the throughput of the ashing process is increased.

In the case where the ions are implanted by plasma doping, it is desirable that if the end of ashing the hardening layer is detected, the ashing process is ended and the removal of the nonhardening layer is made through the process of wet etching. Its reason is that in the case of plasma doping, a high concentration of impurity is implanted onto the upper surface of the silicon substrate as compared with the ion implantation. Therefore, if the entire resist is removed by ashing, the upper surface of the silicon substrate is oxidized, whereby the impurity may not contribute to electrical conduction in some cases. Thus, the resist should be removed without oxidizing the surface as much as possible. In this case, the hardening layer of the resist is only removed by ashing, and the underlying nonhardening layer is removed by wet etching that is less likely to oxidize the silicon than the ashing, whereby the impurity is prevented from not contributing to electrical conduction. Also, it is desirable that its extent is reduced even if the impurity can not be prevented from not contributing.

<EFFECT OF THE INVENTION>

As described above, with the invention, the elipsometer for detecting the interface between the hardening layer that is altered by impurity introduction and the internal nonhardening layer and the interface between the nonhardening layer and the semiconductor substrate is provided to change the ashing rate, whereby the ashing is made in a very short time without causing popping, so that the throughput is increased.

Moreover, for the hardening layer that is altered by plasma doping and the internal nonhardening layer, the hardening layer is removed by ashing and the nonhardening layer is removed by wet etching, whereby it is possible to prevent the impurity from not contributing to electrical conduction or reduce its extent.

<BRIEF DESCRIPTION OF THE DRAWINGS>

Fig. 1 is a typical cross-sectional view of an asher according to an embodiment 1 of the present invention.
Fig. 2 is a typical view of a spectral elipsometer.
Fig. 3 is a view for explaining a process for implanting the impurity into the resist of the semiconductor substrate.
Fig. 4 is a view showing a state where the impurity is implanted.
Fig. 5 is a graph showing the luminous intensity of a spectral light emitted from a reaction product during the low temperature processing and the high temperature processing.
Fig. 6 is a cross-sectional view of a plasma doping apparatus for use in an embodiment 2 of the invention.

<Description of Reference Numerals and Signs>

| | |
|---|---|
| 1 | RF generator |
| 2 | light source |
| 3 | wafer |
| 4 | photometer |
| 5 | control unit |
| 6 | stage |
| 7 | heater |
| 8 | chamber |
| 9 | upper electrode |
| 15a | semiconductor substrate |
| 16 | resist |
| 16a | nonhardening layer |
| 16b | hardening layer |
| 20 | Xe light source |
| 21 | polarizer |
| 22 | analyzer |
| 23 | spectrometer |
| 24 | detector |
| 101 | vacuum vessel |
| 102 | gas supply apparatus |
| 103 | turbo molecular pump |
| 104 | pressure governing valve |
| 105 | RF generator for plasma source |
| 106 | sample electrode |
| 107 | dielectric window |
| 108 | coil |
| 109 | substrate |
| 110 | RF generator for sample electrode |
| 111 | exhaust port |
| 112 | strut |

<BEST MODE FOR CARRYING OUT THE INVENTION>

(Embodiment 1)

The present invention will be described below with reference to the drawings.

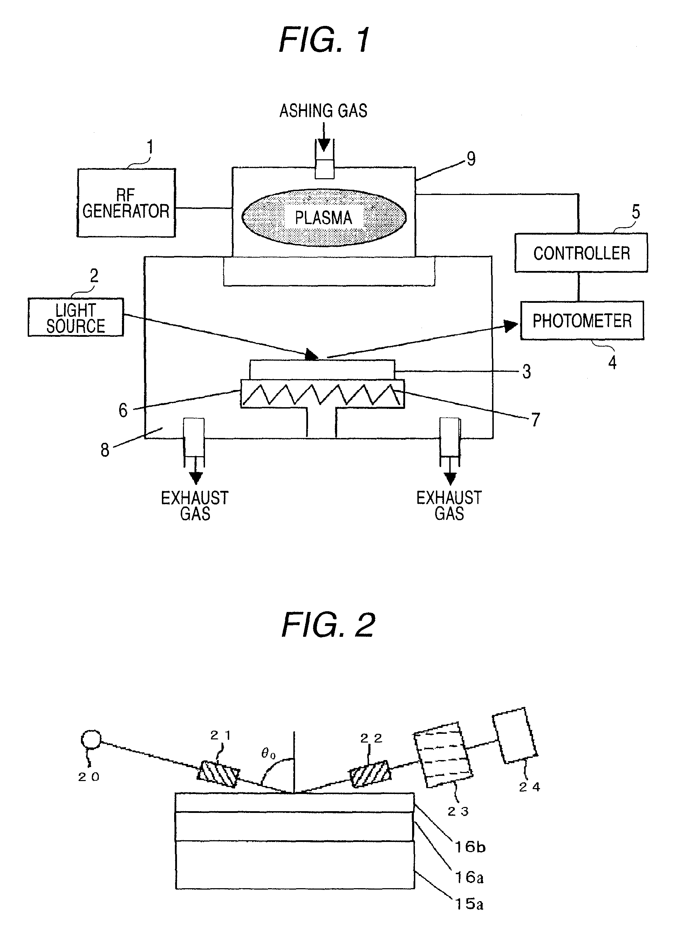

Fig. 1 is a typical cross-sectional view of an asher according to one embodiment of the invention.
This asher comprises a chamber 8 into which an ashing gas is introduced and of which the pressure is reduced by a vacuum pump, an RF generator 1 for applying an RF power to an upper electrode 9 in this chamber 8, a stage 6, opposed to the upper electrode 9, serving as a lower electrode on which a wafer 3 is laid, and a heater 7, contained in this stage 6, for heating the wafer 3, as shown in Fig. 1. Using an ellipsometry, a light from a light source 2 is directed toward the surface of the wafer 3, and measured by a photometer 4, as shown in Fig. 1. The measurement result of the photometer 4 is sent to a control unit 5, and fed back to an ashing process.

Referring to a constitutional view of a spectral ellipsometer of Fig. 2, a method for detecting the interface between the hardening layer and the nonhardening layer and the interface between the nonhardening layer and the semiconductor substrate, or detecting the optical constants and the thickness of the hardening layer and the nonhardening layer will be described below.

An Xe light outputted from an Xe light source 20 is converted into a linearly polarized light by a polarizer 21, and caused to be incident upon the substrate at an angle θ0 to the direction perpendicular to the substrate surface. The angle θ0 is a measured value from 45° to 90°. The axis of linearly polarized light for the incident light is inclined with respect to p direction (direction of the intersection between a plane vertical to the optical axis and a plane including the incident light and reflected light) and s direction (direction vertical to p direction within a plane vertical to the optical axis). It is assumed that the amplitude reflectance ratio between p and s components of the reflected light as elliptically polarized light is $\Psi$ and the phase difference between the p and s components is $\Delta$. In the ellipsometry, the reflected light as elliptically polarized light is passed through an analyzer 22 and caused to be incident on a spectrometer 23, where $\Psi$ and $\Delta$ are measured by a detector 24 while separating light into spectral components.

Comparing a case where the hardening layer is present and a case where the hardening layer is completely ashed, the interface between the hardening layer and the nonhardening layer can be detected from the measurement results of the ellipsometer for $\Psi$ and $\Delta$ because the signals of $\Psi$ and $\Delta$ are different.

After the hardening layer is completely ashed, comparing a case where the nonhardening layer is present and a case where the nonhardening layer is completely ashed, the interface between the nonhardening layer and the semiconductor substrate can be detected from the measurement results of ellipsometer of $\Psi$ and $\Delta$ because the signals of $\Psi$ and $\Delta$ are different.

A method for calculating not only the thickness but also the optical constants (refractive index n and extinction coefficient k) of the hardening layer and the nonhardening layer as unknown parameters from the ellipsometry measurement results of $\Psi$ and $\Delta$ by a least square method will be described below. Using a four layer model of Air/hardening layer/nonhardening layer/c-Si, the thickness and the optical constants (refractive index n and extinction coefficient k) of the hardening layer can be obtained, and it is detected whether or not the ashing process for the hardening layer is completed. After the hardening layer is ashed, the thickness and the optical constants (refractive index n and extinction coefficient k) of the nonhardening layer can be obtained, using a three layer model of Air/nonhardening layer/c-Si, and it is detected whether or not all the ashing process is completed.

The optical constant has fundamentally the wavelength dependency. If the optical constant is measured by changing the wavelength, unknown parameters are increased by the number of measured wavelengths, whereby the optical constant can not be decided. In such a case, the spectrum of the optical constant is represented by an approximate expression including a constant not dependent on the wavelength, and the constant is made unknown parameter, whereby the spectrum of the optical constant can be obtained. There are various refractive index wavelength dispersion models. To treat a strong absorption characteristic of the hardening layer, a K-K (Kramers-Kronig) analysis method is employed in this embodiment. The Tauc-Lorentz analysis, Cody-Lorentz analysis, Forouhi-Bloomer analysis, MDF analysis, band analysis, Tetrahedral analysis, Drude analysis and Lorentz analysis methods may be employed for the refractive index wavelength dispersion model to make the above analysis.

The features of the K-K (Kramers-Kronig) analysis method will be described below.

If a light absorption band for the thin film layer exists in the range of measurement wavelength, not only the refractive index but also the extinction constant can be obtained, using a dispersion expression for complex index of refraction derived from the following Kramers-Kronig relational expression.

[Numerical expression 1]

$$n = 1 + 2/\pi P \int \omega' k/(\omega'^2 - \omega^2) d\omega' \qquad (2\text{-}1)$$

$$k = -2/\pi P \int n/(\omega'^2 - \omega^2) d\omega'$$

Where P is a principal value of the Cauchy's integral, and $\omega$ is the frequency.

This relational expression shows that the refractive index can be estimated from the extinction coefficient if the extinction coefficient is known. If a light absorption band exists in the range of measurement wavelength, the extinction coefficient spectrum in the wavelength region is approximated by a Lorentz type expression.

[Numerical expression 2]

$$k=C1(E-C4)^2/(E^2-C2E+C3) \qquad (2\text{-}2)$$

Wherein E is Photon Energy (eV), and has the following relation with the wavelength $\lambda$(nm).

[Numerical expression 3]

$$E(eV)=1239.84/\lambda(nm) \qquad (2\text{-}3)$$

The following expression of refractive index can be derived by integrating the Kramers-Kronig relational expression (2-1) with the expression (2-2).

[Numerical expression 4]

$$n=C5+f(E) \qquad (2\text{-}4)$$

Where f(E) is the integral value of the expression (2-2) and C5 is an integration constant.

In this KK Analysis, C1, C2, C3, C4 and C5 are parameters, and initial values. C5 is the integration constant, and one of the parameters representing the refractive index, whereby the refractive index of the hardening layer is set to a round number as the initial value. C1 is a substantial extinction coefficient. That is, the value of extinction coefficient at the peak of extinction coefficient spectrum is the initial value.

On the other hand, C2 and C3 have the relation with E(eV) at the peak of the extinction coefficient spectrum, in which the initial value of C2 is set to double E(eV) at the peak and the initial value of C3 is set to the square of E(eV) at the peak. C4 has the relation with the energy band width of absorption band, in which the initial value of C4 is equal to the value of E(eV) at which the extinction coefficient is smallest at the tail of the peak of extinction coefficient spectrum.

As described above, when the KK Analysis is employed, the initial value can be set, supposing the absorption spectrum, or the extinction coefficient spectrum, including the physical properties of the thin film that is measurement object matter, thereby making the analysis.

The optical constants and the thickness of the hardening layer and the nonhardening layer can be detected by the above method. And the end time of ashing the hardening layer and the nonhardening layer can be predicted, whereby the throughput is increased. At the same time, the ashing process can be fed back.

A method for ashing the resist of the wafer 3 into which the impurity is introduced using the asher of Fig. 1 will be described below.

First of all, the pressure of the chamber 8 is reduced in a state where the wafer 3 is laid on the stage 6. If a predetermined pressure is reached, the chamber is evacuated to vacuum while an oxygen gas that is etching gas is introduced, so that the internal pressure of the chamber 8 is kept at a fixed pressure. On the other hand, the wafer 3 is maintained at low temperature by setting the temperature of the heater 7.

If these conditions are obtained, an RF power at low ashing rate is applied to generate an oxygen plasma and start the ashing. At the same time, $\psi$ and $\Delta$ are measured using the ellipsometer.

If $\psi$ and $\Delta$ are greatly changed during ashing, it is judged that the hardening layer is ashed, whereby the RF power is increased, for example, 1.5 times to make the ashing rate higher, and the ashing is performed. Thereby, the nonhardening layer of the resist is ashed at a high ashing rate earlier than conventionally, whereby the overall ashing time is shortened.

Or if the thickness of the hardening layer reaches zero while monitoring the optical constants and the thickness of the hardening layer, it is determined that the hardening layer is ashed, whereby the RF power is increased, for example, 1.5 times to make the ashing rate higher and the ashing is performed.

Thereby, the nonhardening layer of the resist is ashed at the high ashing rate earlier than conventionally, whereby the overall ashing time is shortened.

Also, after the hardening layer is ashed, the thickness and optical constants (refractive index n and extinction coefficient k) of the nonhardening layer are detected, and it is detected whether or not all the ashing process is completed.

And if all the ashing process is completed, the ashing is ended.

Though the RF power is changed to change the ashing rate in this system, the temperature of the wafer 3 may be changed if means for heating the wafer 3 is a lamp. Besides, the mixture ratio of oxygen gas and Freon gas may be changed.

When the plasma doping method is used for impurity doping, the doping and ashing process can be completed within the apparatus of a so-called multi-chamber in which a plurality of plasma chambers are provided. Or one series of impurity doping processes may be performed in an apparatus group for performing the consecutive processes, though they are disposed as separate apparatuses for the sake of convenience.

(Embodiment 2)

A crystalline layer on the surface of a silicon substrate 109 was made amorphous, using a helium gas plasma.

Fig. 6 is a cross-sectional view of a plasma doping chamber in a plasma doping apparatus for use in an embodiment 2 of the invention. In Fig. 6, a predetermined gas is introduced from a gas supply apparatus 102 into a vacuum vessel 101, which is then evacuated by a turbo molecular pump 103 as an evacuator, so that the vacuum vessel 101 can be kept at a predetermined pressure by a pressure governing valve 104. An inductive coupled plasma can be generated within the vacuum vessel 101 by supplying an RF power of 13.56MHz from an RF generator 105 to a coil 108 provided near a dielectric window 107 opposed to a sample electrode 106. The silicon substrate 109 as a sample is laid on the sample electrode 106. Also, an RF generator 110 for supplying the RF power to the sample electrode 106 is provided to function as a voltage source for controlling the potential of the sample electrode 106 so that the substrate 109 as the sample may have a negative potential to the plasma. In this manner, ions in the plasma are accelerated toward the surface of the sample to collide with it to make the surface of the sample amorphous or introduce the impurity. The gas supplied from the gas supply apparatus 102 is exhausted out of an exhaust port 111 into a pump 103. The turbo molecular pump 103 and the exhaust port 111 are placed directly under the sample electrode 106. Also, the pressure governing valve 104 is a lift valve located directly under the sample electrode 106 and directly above the turbo molecular pump 103. The sample electrode 106 is fixed to the vacuum vessel 101 by four struts 112.

After the substrate 109 is laid on the sample electrode 106, the vacuum vessel 101 is evacuated out of the exhaust port 111 while the temperature of the sample electrode 106 is kept at 25°C. Then, a helium gas of 50sccm is supplied from the gas supply apparatus 102 into the vacuum vessel 101, and the pressure of the vacuum vessel 101 is kept at 1 Pa by controlling the pressure governing valve 104. Then, a plasma is generated within the vacuum vessel 101 by supplying an RF power of 800W to the coil 108 as a plasma source, and the crystalline layer on the surface of the silicon substrate 109 is made amorphous by supplying an RF power of 200W to a base of the sample electrode 106. The exposure time to the helium plasma is 7 seconds. A resist is patterned on the surface of the silicon substrate 109. Some part of the surface of the silicon substrate is exposed from a gap in the resist. After the amorphous treatment, boron of $3E14cm^{-2}$ was implanted by ion implantation. The hardening layer was present on the surface of resist. The hardening layer of resist was removed by ashing. Thereafter, the nonhardening layer 16a was removed by wet etching. Thereafter, the activation process was performed with spike RTA at 1070°C to measure the sheet resistance.

At this time, helium implanted into the silicon substrate was $1E16cm^{-2}$. It is considered that the hardening layer on the resist surface is formed by plasma doping of helium. For comparison, a solid silicon substrate without resist pattern was prepared, made amorphous by helium plasma, and doped with boron by ion implantation, whereby the activation process was performed with spike RTA at 1070°C to measure the sheet resistance. In this case, the sheet resistance was equivalent to the sheet resistance in the case where after the hardening layer of resist was removed by ashing, the nonhardening layer 16a was removed by wet etching.

For further comparison, a silicon substrate with the patterned resist was made amorphous by helium plasma and doped with boron by ion implantation, whereby after the entire resist was removed by ashing, the activation process was performed with spike RTA at 1070°C to measure the sheet resistance. In this case, the sheet resistance was greater than the sheet resistance in the case where after the hardening layer of resist was removed by ashing, the nonhardening layer 16a was removed by wet etching. It is considered that the percentage of impurity not contributing to electrical conduction is increased.

(Embodiment 3)

A silicon substrate was doped with boron by plasma doping using a mixed gas plasma of $B_2H_6$ and He.

Herein, a plasma doping chamber of a plasma doping apparatus of Fig. 6 used in the embodiment 2 of the invention is used. In Fig. 6, a vacuum chamber 101 is evacuated by a turbo molecular pump 103 as an evacuator while a predetermined gas is introduced from a gas supply apparatus 102 into the vacuum vessel 101, so that the vacuum chamber 101 can be kept at a predetermined pressure by a pressure governing valve 104. By supplying an RF power of 13.56MHz from an RF generator 105 to a coil 108 provided near a dielectric window 107 opposed to a sample electrode 106, an inductive coupled plasma can be generated within the vacuum vessel 101. The silicon substrate 109 as a sample is laid on the sample electrode 106. Also, an RF generator 110 for supplying RF power to the sample electrode 106 is provided to function as a voltage source for controlling the potential of the sample electrode 106 so that the substrate 109 as the sample may have a negative potential to the plasma. In this manner, ions in the plasma are accelerated toward the surface of the sample to collide with it to make the surface of the sample amorphous or introduce the impurity. The gas supplied from the gas supply apparatus 102 is exhausted out of an exhaust port 111 into a pump 103. The turbo molecular pump 103 and the exhaust port 111 are placed directly under the sample electrode 106. Also, the pressure governing valve 104 is a lift valve located directly under the sample electrode 106 and directly above the turbo molecular pump 103. The sample electrode 106 is a base of almost square shape on which the substrate 109 is laid, and fixed to the vacuum vessel 101 by a strut 112 on each side, or by a total of four struts 112.

After the substrate 109 is laid on the sample electrode 106, a plasma was generated within the vacuum vessel 101 by supplying helium (He) gas of 97sccm and $B_2H_6$ gas of 3sccm into the vacuum vessel 1 while the temperature of the sample electrode 106 is kept at 25°C, and by supplying an RF power of 1000W to the coil 108 while the pressure of the vacuum vessel 1 is kept at 0.9Pa, and boron was introduced near the surface of the substrate 109 by supplying an RF power of 250W to the sample electrode 106. The gas mixture ratio was equivalent to $B_2H_6$ 3% to He 97%.

The plasma-doping time was adjusted so that the dose of boron into the silicon substrate might be $1E14cm^{-2}$. The resist is patterned on the surface of the silicon substrate 109. Some part of the surface of the silicon substrate is exposed from a gap in the resist. The hardening layer was present on the surface of resist after plasma doping. The hardening layer of resist was removed by ashing. Thereafter, the nonhardening layer 16a was removed by wet etching. Thereafter, the activation process was performed with spike RTA at 1070°C to measure the sheet resistance.

At this time, boron implanted into the silicon substrate was $1E14cm^{-2}$. However, other than boron, hydrogen of $3E14cm^{-2}$ and helium of $4E15cm^{-2}$ were implanted. It is considered that the hardening layer on the resist surface is formed by plasma doping of helium. If the mixture ratio of helium gas is 97% or more, more amount of helium is implanted than boron, so that the hardening layer on the resist surface is more easily formed. Also, if boron of $1E14cm^{-2}$ or more is implanted, helium is increased along with increased dose of boron, so that the hardening layer on the resist surface is more easily formed.

For comparison, a solid silicon substrate without resist pattern was prepared, boron was implanted by plasma doping, and the activation process was performed with spike RTA at 1070°C to measure the sheet resistance. In this case, the sheet resistance was equivalent to the sheet resistance in the case where after the hardening layer of the resist was removed by ashing, the nonhardening layer 16a was removed by wet etching.

For further comparison, boron was implanted into a silicon substrate with patterned resist by plasma doping, and after the entire resist was removed only by ashing, the activation process with spike RTA at 1070°C was performed to measure the sheet resistance. In this case, the sheet resistance was greater than where after the hardening layer of the resist was removed by ashing, the nonhardening layer 16a was removed by wet etching. It is considered that the percentage of impurity not contributing to electrical conduction was increased.

While the invention has been described above in detail with reference to the specific embodiment, it will be apparent to those skilled in the art that various changes or modifications may be made without departing from the spirit and scope of the invention.

This application is based on Japanese Patent Application with Application No. 2005-099148, filed on March 30, 2005, the contents of which are incorporated herein by reference.

<INDUSTRIAL APPLICABILITY>

The asher, the ashing method and the impurity doping apparatus group of the invention are effective to form the electronic devices such as condenser, varistor, diode, transistor and coil, because it is possible to detect the interface between the surface hardening layer of the resist after impurity doping and the internal nonhardening layer and the interface between the nonhardening layer and the semiconductor substrate, whereby the throughput of ashing is increased.

**Claims**

1. An asher, including:

   a mechanism for removing a hardening layer formed by introducing a material different from a photo-resist material into the photo-resist material formed on the surface of a solid sample and an nonhardening layer inside the photo-resist by causing a linearly polarized light to enter said solid sample to detect an elliptically polarized light reflected from said solid sample and detecting the interface between said hardening layer and said nonhardening layer and the interface between said nonhardening layer and said solid sample.

2.  The asher for ashing the photo-resist formed on a semiconductor substrate and doped with impurity according to claim 1, comprising:

    a mechanism for plasma ashing the surface hardening layer formed on said resist and the internal nonhardening layer by causing a linearly polarized light to enter a semiconductor substrate to detect an elliptically polarized light reflected from said semiconductor substrate and detecting the interface between said hardening layer and said nonhardening layer and the interface between said nonhardening layer and said semiconductor substrate.

3.  The asher according to claim 2, wherein said impurity doping is performed in a plasma doping mechanism.

4.  The asher according to claim 2, wherein said impurity doping makes the surface of the silicon substrate amorphous by applying a plasma.

5.  The asher according to claim 2, wherein said impurity doping makes the surface of the silicon substrate amorphous by applying a helium plasma.

6.  The asher according to claim 1 or 2, wherein said detection mechanism is an ellipsometer.

7.  An impurity doping apparatus comprising a plasma doping apparatus for performing the impurity doping on the substrate surface, and the asher according to any of claims 1 to 6, wherein the plasma doping and the ashing as an after-treatment of the plasma doping process are performed consecutively.

8.  An ashing method of detecting the optical constants and the thickness of said hardening layer and said nonhardening layer by detecting said reflected, elliptically polarized light using the ellipsometer according to claim 6 or 7.

9.  The asher according to any one of claims 1 to 6, comprising a feedback control mechanism for controlling an ashing process in accordance with the detected interface between the hardening layer and the nonhardening layer and interface between said nonhardening later and the semiconductor substrate, or the optical constants and the thickness of the hardening layer and the nonhardening layer detected by the method according to claim 8.

10. An impurity doping apparatus group that can perform the plasma doping and the ashing consecutively, wherein the asher is intended to perform the ashing as an after-treatment of the plasma doping process according to claim 7 for controlling the ashing process in accordance with the detected interface between the hardening layer and the nonhardening layer and interface between said nonhardening later and the semiconductor substrate, or the optical constants and the thickness of the hardening layer and the nonhardening layer detected by the method according to claim 8.

11. A manufacturing method for a semiconductor device, using the asher according to any one of claims 1 to 6, including a process of removing the plasma doped photo-resist formed on the semiconductor substrate, the removal of the surface hardening layer formed on said resist being performed by ashing and the removal of the internal nonhardening layer being performed by wet etching.

12. The manufacturing method for the semiconductor device according to claim 11, wherein said plasma doping uses a plasma containing boron.

13. The manufacturing method for the semiconductor device according to claim 12, wherein said plasma doping uses a plasma containing a mixed gas of $B_2H_6$ and He.

14. The manufacturing method for the semiconductor device according to claim 13, wherein the plasma doping uses a plasma containing a mixed gas of $B_2H_6$ and He in which the ratio of $B_2H_6$ to He is 3% or less of $B_2H_6$ to 97% or more of He, and the dose of boron into the silicon substrate is $1E14 cm^{-2}$ or more.

# FIG. 1

ASHING GAS

RF GENERATOR 1

PLASMA 9

CONTROLLER 5

LIGHT SOURCE 2

PHOTOMETER 4

3

6

7

8

EXHAUST GAS

EXHAUST GAS

# FIG. 2

20

21

$\theta_0$

22

23

24

16b

16a

15a

## FIG. 3

INTRODUCING IMPURITY

16

1 5 a    1 5 a    1 6    1 5 a

## FIG. 4

1 6 b

1 6 a

1 5 a

## FIG. 5

## FIG. 6

## INTERNATIONAL SEARCH REPORT

| International application No. |
|---|
| PCT/JP2006/306740 |

A. CLASSIFICATION OF SUBJECT MATTER
*H01L21/3065*(2006.01), *H01L21/027*(2006.01), *H01L21/22*(2006.01), *H01L21/265*
(2006.01)

According to International Patent Classification (IPC) or to both national classification and IPC

B. FIELDS SEARCHED

Minimum documentation searched (classification system followed by classification symbols)
H01L21/3065, H01L21/027, H01L21/22, H01L21/265, G01B11/06, G01N21/21

Documentation searched other than minimum documentation to the extent that such documents are included in the fields searched
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)
JSTPlus(JDream2)

C. DOCUMENTS CONSIDERED TO BE RELEVANT

| Category* | Citation of document, with indication, where appropriate, of the relevant passages | Relevant to claim No. |
|---|---|---|
| A | WO 1998/057146 A1 (Matsushita Electronics Corp.), 17 December, 1998 (17.12.98), Full text & JP 2001-230291 A & US 6128084 A | 1-14 |
| A | JP 2004-535673 A (Axcelis Technologies, Inc.), 25 November, 2004 (25.11.04), Full text & WO 2003/007327 A2 & US 2003/0062337 A1 & CN 1554107 A | 1-14 |
| A | JP 01-232202 A (Teru Kyushu Kabushiki Kaisha), 18 September, 1989 (18.09.89), Full text (Family: none) | 1-14 |

☐ Further documents are listed in the continuation of Box C.    ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 09 June, 2006 (09.06.06) | 20 June, 2006 (20.06.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

**EP 1 865 547 A1**

## REFERENCES CITED IN THE DESCRIPTION

### Patent documents cited in the description

- JP 6124923 A
- JP 2005099148 A